(19) Europäisches Patentamt
European Patent Office
Office européen des brevets

(11) **EP 4 037 194 B1**

(12) **EUROPEAN PATENT SPECIFICATION**

(45) Date of publication and mention
of the grant of the patent:
**24.04.2024 Bulletin 2024/17**

(21) Application number: **20872832.9**

(22) Date of filing: **22.09.2020**

(51) International Patent Classification (IPC):
*H03M 7/30* *(2006.01)*     *H03M 13/13* *(2006.01)*
*H04N 19/129* *(2014.01)*     *H04N 19/13* *(2014.01)*
*H04N 19/85* *(2014.01)*

(52) Cooperative Patent Classification (CPC):
**H03M 13/6597; H03M 13/13; H03M 13/6312;**
**H04N 19/129; H04N 19/13; H04N 19/85;**
H03M 7/3071; H03M 7/6041

(86) International application number:
**PCT/CN2020/116857**

(87) International publication number:
**WO 2021/063218 (08.04.2021 Gazette 2021/14)**

(54) **IMAGE SIGNAL PROCESSING METHOD AND APPARATUS**

BILDSIGNALVERARBEITUNGSVERFAHREN UND -VORRICHTUNG

PROCÉDÉ ET APPAREIL DE TRAITEMENT DE SIGNAL D'IMAGE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **30.09.2019 CN 201910942101**

(43) Date of publication of application:
**03.08.2022 Bulletin 2022/31**

(73) Proprietor: **Huawei Technologies Co., Ltd.**
**Longgang District**
**Shenzhen, Guangdong**
**518129 (CN)**

(72) Inventors:
• **GU, Jiaqi**
**Shenzhen, Guangdong 518129 (CN)**
• **LIU, Ling**
**Shenzhen, Guangdong 518129 (CN)**
• **LI, Bin**
**Shenzhen, Guangdong 518129 (CN)**
• **SHEN, Hui**
**Shenzhen, Guangdong 518129 (CN)**

(74) Representative: **Thun, Clemens**
**Mitscherlich PartmbB**
**Patent- und Rechtsanwälte**
**Karlstraße 7**
**80333 München (DE)**

(56) References cited:
**WO-A1-2018/191908**     **CN-A- 104 918 063**
**CN-A- 107 666 324**     **CN-A- 109 150 384**
**CN-A- 109 286 468**     **US-A1- 2011 051 836**
**US-A1- 2015 333 775**

• **HARM S CRONIE ET AL: "Lossless source coding with polar codes", PROC., IEEE INTERNATIONAL SYMPOSIUM ON INFORMATION THEORY, ISIT 2010, IEEE, PISCATAWAY, NJ, USA, 13 June 2010 (2010-06-13), pages 904-908, XP031710599, ISBN: 978-1-4244-7890-3**
• **NADINE HUSSAMI ET AL: "Performance of Polar Codes for Channel and Source Coding", ARXIV.ORG, CORNELL UNIVERSITY LIBRARY, 201 OLIN LIBRARY CORNELL UNIVERSITY ITHACA, NY 14853, 16 January 2009 (2009-01-16), XP080357414, DOI: 10.1109/ISIT.2009.5205860**

EP 4 037 194 B1

- **Korada Satish Babu: "Polar Codes for Channel and Source Coding", Ph.D. Thesis, 28 May 2009 (2009-05-28), pages 1-181, XP055974593, DOI: http://dx.doi.org/10.5075/epfl-thesis-4461 Retrieved from the Internet: URL:https://infoscience.epfl.ch/record/138 655/files/EPFL_TH4461.pdf [retrieved on 2022-10-25]**

## Description

### TECHNICAL FIELD

Embodiments of this application relate to the field of image processing, and in particular, to an image signal processing method and apparatus

### BACKGROUND

There are a plurality of conventional joint photographic experts group (joint photographic experts group, JPEG) image compression solutions, for example, Huffman coding and arithmetic coding are currently commonly used compression solutions of entropy coding.

The Huffman coding is a compression solution that allocates short binary bits to characters with a high occurrence probability to perform coding, and allocates long binary bits to characters with a low occurrence probability to perform coding, so that an average coding length of the characters is the shortest. The Huffman coding needs to first calculate an occurrence frequency of each character in original data, generate a corresponding dictionary, and then perform coding. An entire coding process has a high compression rate and is complex to implement. Once a decoding error occurs, error spreading at a decoder is serious, which affects image compression performance.

How to easily and effectively control error spreading at the decoder to improve image compression performance is a problem to be urgently resolved.

The document Harm S Cronie et al.: "Lossless source coding with polar codes", Proc., IEEE International Symposium on Information Theory, ISIT 2010, 13 June 2010, pp. 904-908, XP031710599 shows a method for source coding data using polar codes

The document Nadine Hussami et al.: "Performance of polar codes for channel and source coding", ARXIV.ORG, CORNELL UNIVERSITY LIBRARY, 201 OLIN LIBRARY CORNELL UNIVERSITY ITHACA, NY 14853, 16 January 2009, XP080357414 shows a method for performing channel and source coding by use of polar codes.

The document Korada Satish Babu: "Polar codes for channel and source coding", Ph.D. Thesis, EPFL Lausanne, 28 May 2009, pages 1-181, XP055974593, also shows a method for employing polar codes in source and channel coding

### SUMMARY

The present invention is defined by the independent claims. Further advantageous developments are shown by the dependent claims.

This application provides an image signal processing method and apparatus. The solution is easy to implement, has a low compression rate, and effectively controls error spreading at a decoder, to improve image compression performance.

To achieve the foregoing objective, the following technical solutions are used in embodiments of this application.

According to a first aspect, an image signal processing method is provided, where the method is applied to an encoder. The method may include: obtaining a binary source $X^N$ of an image; performing a polarization operation on $X^N$, to obtain a to-be-compressed bit set $U^N$; obtaining a compressed reserved bit set $U_S$ from $U^N$; performing channel coding on $U_S$, to obtain a coded bit sequence; and outputting the coded bit sequence.

According to the image signal processing method provided in this application, the binary source is compressed through polar coding, and fixed-length source coding is implemented based on an expected compression rate. This process is easy to implement. In addition, a coding granularity of the polar coding is an image block (block). Even if a decoding error occurs, the error spreads only in the block, thereby effectively controlling error spreading at a decoder, and improving image compression performance.

The polarization operation may be multiplying a generation matrix of a polar code.

A bit in $U_S$ is a reserved bit during source compression, and $U_S$ are some bits in $U^N$.

Optionally, a source entropy of the bit in $U_S$ approximates 1; or a source entropy of the bit in $U_S$ tends to be greater than or equal to a first preset threshold; or a Bhattacharyya parameter of an equivalent channel corresponding to the bit in $U_S$ is greater than or equal to a second preset threshold; or a channel capacity of an equivalent channel corresponding to the bit in $U_S$ is less than or equal to a third preset threshold.

With reference to the first aspect, in a possible implementation, the obtaining a compressed reserved bit $U_S$ from $U^N$ may be specifically implemented as: converting source coding into channel coding; and using, based on a sequence of equivalent channel reliability in descending order, bits corresponding to equivalent channel reliability ranked low in $U^N$ as $U_S$. A higher source entropy of a source bit indicates lower reliability of an equivalent channel corresponding to the source bit.

Source coding is equivalent to channel decoding. A channel reliability ranking algorithm is used during channel decoding, to obtain the sequence of the channel reliability in descending order, and the sequence is used as a sequence of source entropies of bits in ascending order in $U^N$. Fixed bits $U_F$ of an equivalent channel are used as $U_S$ (that is, $U_F \leftrightarrow U_S$), and information bits $U_I$ of the equivalent channel are used as $U_{SC}$ (that is, $U_I \leftrightarrow U_{Sc}$).

For example, the channel reliability ranking algorithm may include a Gaussian approximation (Gaussian Approximation) algorithm, a channel degradation and upgradation merging (channel degradation and upgradation merging) algorithm, some ranking methods, or the like.

Specifically, the using bits corresponding to equivalent channel reliability ranked low in $U^N$ as $U_S$ includes: using, based on the sequence of the equivalent channel reliability in descending order, A bits corresponding to equivalent channel reliability ranked low in $U^N$ as $U_S$, where A is determined by the expected compression rate. This is not limited in this application.

With reference to the first aspect, in a possible implementation, the obtaining a compressed reserved bit $U_S$ from $U^N$ may be specifically implemented as: calculating a source entropy of each bit in $U^N$, and using bits whose source entropies approximate 1 in $U^N$ as $U_S$. A process of calculating the source entropies may be implemented through mathematical derivation.

With reference to the first aspect or any one of the foregoing possible implementations, in another possible implementation, $U^N$ further includes a compressed discarded bit set $U_{SC}$ obtained through polar code source coding, where $U_{SC}$ is a complementary set of $U_S$, and includes bits other than $U_S$ in $U^N$. The image signal processing method provided in this application may further include: performing channel decoding on preset output values of an equivalent channel based on $U_S$, to obtain a decoded $U'_{S^C}$ ; obtaining error location information $T$ based on $U_{SC}$ and $U'_{S^C}$ ; and recording $U_S$ and $T$, to train a preset neural network for predicting the error location information. The preset neural network is a neural network that is trained based on M groups of compressed reserved bit sets and error location information obtained through polar code source coding until the neural network converges. A value of M may be configured based on an actual requirement.

The performing channel decoding on preset output values of an equivalent channel based on $U_S$, to obtain a decoded $U'_{S^C}$ may include: equating a process of performing source coding on a binary Bernoulli source to a process of performing channel decoding on a binary symmetric channel (binary symmetric channel, BSC), which is equivalent to one BSC. Noise distribution of the channel is the same as that of $X^N$, the preset output values of the preset equivalent channel are used as a received signal of the BSC, $U_S$ is used as fixed bits $U_F$ included in the received signal, the preset output values of the equivalent channel and $U_F$ are input into a polar code decoder to perform channel decoding, to obtain estimated values $U'_I$ of the information bits $U_I$ , and $U'_I$ is used as estimated values $U'_{S^C}$ of $U_{SC}$.

The preset output values of the equivalent channel may be an all-zero set, or may be other preset values. This is not specifically limited in this application. The error location information $T$ records locations of different bits in $U_{SC}$ and $U'_{S^C}$ .

With reference to the first aspect or any one of the foregoing possible implementations, $U^N$ further includes a compressed discarded bit set $U_{SC}$ obtained through polar code source coding, where $U_{SC}$ is a complementary set of $U_S$, and includes bits other than $U_S$ in $U^N$. The image signal processing method provided in this application further includes: performing channel decoding on preset output values of an equivalent channel based on $U_S$, to obtain a decoded $U'_{S^C}$ ; and obtaining error location information $T$ based on $U_{SC}$ and $U'_{S^C}$ . In an example not forming part of the claimed invention, the performing channel coding on $U_S$, to obtain a coded bit sequence may be specifically implemented as: performing channel coding on $U_S$ and $T$, to obtain the coded bit sequence. The decoder performs decoding based on $T$, to implement lossless compression of the image.

It should be noted that before channel coding is performed on $T$, $T$ further needs to be converted into a binary form.

With reference to the first aspect or any one of the foregoing possible implementations, in another possible implementation, the obtaining a binary source $X^N$ of an image includes: performing color conversion, grayscale translation, discrete cosine transform (discrete cosine transform, DCT), quantization, and zig-zag scanning on the image, to obtain $X^N$.

With reference to the first aspect or any one of the foregoing possible implementations, in another possible implementation, the obtaining a binary source $X^N$ of an image includes: performing color conversion, grayscale translation, DCT, quantization, zig-zag scanning, and entropy coding on the image, to obtain $X^N$ . The entropy coding may include run-length coding or the like.

According to a second aspect, another image signal processing method is provided, where the method is applied to a decoder. The method may include: obtaining a received signal $Y^N$, where $Y^N$ is a signal obtained after a bit sequence that is obtained after source coding and channel coding are performed on a binary source $X^N$ of an image is transmitted through a channel; performing channel decoding on $Y^N$, to obtain information bits $\hat{U}_I$ in channel decoding, and using $\hat{U}_I$ as a compressed reserved bit set $\hat{U}_S$ on which source decoding is to be performed; performing channel decoding on preset output values of an equivalent channel based on error location information $\hat{T}$ and $\hat{U}_S$, to obtain a compressed discarded bit set $\hat{U}_{SC}$ on which source decoding is to be performed, where $\hat{T}$ indicates a location of a flipped bit during channel decoding; obtaining $\hat{U}^N$, where $\hat{U}^N$ includes $\hat{U}_S$ and $\hat{U}_{SC}$; and performing a polarization operation on $\hat{U}^N$, to obtain a reconstructed signal $\hat{X}^N$ of $X^N$.

According to the image signal processing method provided in this application, corresponding decoding is performed, based on the error location information, on the signal that is compressed through polar coding, to implement lossless compression of the image signal. This process is easy to implement. In addition, a coding granularity of the polar coding is an image block (block). Even if a decoding error occurs, the error spreads only in the block, thereby effectively controlling error spreading at a decoder, and improving image compression performance.

With reference to the second aspect, in a possible implementation, the image signal processing method provided in this application further includes: inputting $U_S$ to a preset neural network, to obtain the error location information $\hat{T}$ through prediction. The preset neural network is a neural network that is trained based on M groups of compressed reserved bit sets and error location information obtained through polar code source coding until the neural network converges.

The preset neural network may perform training offline based on data, recorded by an encoder, of the M groups of compressed reserved bit sets and error location information obtained through polar code source coding, and trained data is configured in the decoder.

In an example not forming part of the claimed invention, the performing channel decoding on $Y^N$, to obtain information bits $\hat{U}_I$ in channel decoding may be specifically implemented as: performing channel decoding on $Y^N$, to obtain $\hat{U}_I$ and $\hat{T}$. $\hat{T}$ is sent by the encoder, to achieve lossless image compression.

Further, in the example not forming part of the claimed invention, $\hat{T}$ obtained through channel decoding further needs to be converted into a decimal form.

With reference to the second aspect or any one of the foregoing possible implementations, in another possible implementation, the image signal processing method provided in this application further includes: performing inverse zig-zag scanning, dequantization, inverse discrete cosine transform (inverse discrete cosine transform, IDCT), grayscale translation addition, color conversion, and the like on $\hat{X}^N$, to restore the image.

With reference to the first aspect or any one of the foregoing possible implementations, in another possible implementation, the obtaining a binary source $X^N$ of an image includes: performing entropy coding, inverse zig-zag scanning, dequantization, IDCT, grayscale translation, color conversion, and the like on $\hat{X}^N$, to restore the image. The entropy coding may include run-length coding or decoding corresponding to another entropy coding.

According to a third aspect, an image signal processing apparatus is provided. The apparatus may be an encoder, or may be an apparatus or a chip system in an encoder. The image signal processing apparatus may implement the functions in the first aspect or the possible implementations of the first aspect; and the functions may be implemented through hardware, or may be implemented through hardware executing corresponding software. The hardware or the software includes one or more modules corresponding to the functions. The image signal processing apparatus may include a first obtaining unit, a polarization unit, an obtaining unit, a coding unit, and an output unit.

The first obtaining unit is configured to obtain a binary source $X^N$ of an image.

The polarization unit is configured to perform a polarization operation on $X^N$ obtained by the first obtaining unit, to obtain a to-be-compressed bit set $U^N$.

The obtaining unit is configured to obtain a compressed reserved bit set $U_S$ from $U^N$ obtained by the polarization unit.

The coding unit is configured to perform channel coding on $U_S$ obtained by the obtaining unit, to obtain a coded bit sequence.

The output unit is configured to output the coded bit sequence obtained by the coding unit.

With reference to the third aspect, in a possible implementation, the obtaining unit may be specifically configured to: use, based on a sequence of equivalent channel reliability in descending order, bits corresponding to equivalent channel reliability ranked low in $U^N$ as $U_S$. A higher source entropy of a source bit indicates lower reliability of an equivalent channel corresponding to the source bit.

With reference to the third aspect or any one of the foregoing possible implementations, in another possible implementation, $U^N$ further includes a compressed discarded bit set $U_{SC}$ obtained through polar code source coding. The apparatus may further include a second obtaining unit, configured to: perform channel decoding on preset output values of an equivalent channel based on $U_S$, to obtain a decoded $\hat{U}'_{S^C}$ ; and obtain error location information $T$ based on $U_{SC}$ and $\hat{U}'_{S^C}$ ; and a recording unit, configured to record $U_S$ and $T$, to train a preset neural network for predicting the error location information. The preset neural network is a neural network that is trained based on M groups of compressed reserved bit sets and error location information obtained through polar code source coding until the neural network converges.

With reference to the third aspect or any one of the foregoing possible implementations, in another possible implementation, $U^N$ further includes a compressed discarded bit set $U_{SC}$ obtained through polar code source coding. The apparatus may further include a second obtaining unit, configured to: perform channel decoding on preset output values of an equivalent channel based on $U_S$, to obtain a decoded $\hat{U}'_{S^C}$ ; and obtain error location information $T$ based on $U_{SC}$ and $\hat{U}'_{S^C}$ . Correspondingly, the coding unit may be specifically configured to perform channel coding on $U_S$ and $T$.

It should be noted that the image signal processing apparatus provided in the third aspect is configured to perform the image signal processing method provided in any one of the first aspect or the possible implementations of the first aspect. For specific implementations, reference may be made to each other, or a same effect may be achieved.

According to a fourth aspect, another image signal processing apparatus is provided. The apparatus may be a decoder, or may be an apparatus or a chip system in a decoder. The image signal processing apparatus may implement the functions in the second aspect or the possible implementations of the second aspect; and the functions may be implemented through hardware, or may be implemented through hardware executing corresponding software. The hardware or the software includes one or more modules corresponding to the functions. The apparatus may include an obtaining unit, a first decoding unit, a second decoding unit, an obtaining unit, and a polarization unit.

The obtaining unit is configured to obtain a received signal $Y^N$, where $Y^N$ is a signal obtained after a bit sequence that is obtained after source coding and channel coding are performed on a binary source $X^N$ of an image is transmitted through a channel;

The first decoding unit is configured to: perform channel decoding on $Y^N$ obtained by the obtaining unit, to obtain information bits $\hat{U}_I$ in channel decoding; and use the information bits as a compressed reserved bit set $\hat{U}_S$ on which source decoding is to be performed.

The second decoding unit is configured to perform channel decoding on preset output values of an equivalent channel based on error location information $\hat{T}$ and $\hat{U}_S$, to obtain a compressed discarded bit set $\hat{U}_{SC}$ on which source decoding is to be performed. $\hat{T}$ indicates a location of a flipped bit during channel decoding.

The obtaining unit is configured to obtain $\hat{U}^N$, where $U^N$ includes $\hat{U}_S$ obtained by the first decoding unit and $U_{SC}$ obtained by the second decoding unit.

The polarization unit is configured to: perform a polarization operation on $\hat{U}^N$ obtained by the obtaining unit, to obtain a reconstructed signal $\hat{X}^N$ of $X^N$.

With reference to the fourth aspect, in a possible implementation, the apparatus may further include a prediction unit, configured to: input $\hat{U}_S$ to a preset neural network, to obtain the error location information $\hat{T}$ through prediction. The preset neural network is a neural network that is trained based on M groups of compressed reserved bit sets and error location information obtained through polar code source coding until the neural network converges.

With reference to the fourth aspect, in an example not forming part of the claimed invention, the first decoding unit may be specifically configured to perform channel decoding on $Y^N$, to obtain $\hat{U}_I$ and $\hat{T}$.

It should be noted that the image signal processing apparatus provided in the fourth aspect is configured to perform the image signal processing method provided in any one of the second aspect or the possible implementations of the second aspect. For specific implementations, reference may be made to each other, or a same effect may be achieved.

According to a fifth aspect, an encoder is provided. The encoder includes a processor and a memory. The memory is configured to store computer-readable instructions (or referred to as computer programs), and the processor is configured to read the computer-readable instructions to implement the method provided in the first aspect and any implementation of the first aspect.

In a possible implementation, the encoder further includes a transceiver, configured to receive and send data.

According to a sixth aspect, a decoder is provided. The decoder includes a processor and a memory. The memory is configured to store computer-readable instructions (or referred to as computer programs), and the processor is configured to read the computer-readable instructions to implement the method provided in the second aspect and any implementation of the second aspect.

In a possible implementation, the decoder further includes a transceiver, configured to receive and send data.

According to a seventh aspect, an embodiment of this application further provides a computer-readable storage medium, including instructions. When the instructions are run on a computer, the computer is enabled to perform the image signal processing method according to any one of the foregoing aspects or any possible implementation of the aspects.

According to an eighth aspect, an embodiment of this application further provides a computer program product. When the computer program product runs on a computer, the computer is enabled to perform the image signal processing method according to any one of the foregoing aspects or any possible implementation of the aspects.

According to a ninth aspect, an embodiment of this application provides a chip system. The chip system includes a processor, and may further include a memory, configured to implement a function of the image signal processing method according to any one of the foregoing aspects or any possible implementation of the aspects. The chip system may include a chip, or may include a chip and another discrete component.

According to a tenth aspect, a chip system is provided, where the chip system includes a processor and a memory. The memory is configured to store computer-readable instructions or a computer program, and the processor is configured to read the computer-readable instructions to implement the image signal processing method according to any one of the foregoing aspects or any possible implementation of the aspects.

According to an eleventh aspect, an image signal processing system is provided. The image signal processing system includes: an encoder according to any one of the foregoing aspects or any possible implementation of the aspects, and a decoder according to any one of the foregoing aspects or any possible implementation of the aspects.

It should be noted that various possible implementations of any one of the foregoing aspects may be combined provided that the solutions are not contradictory.

## BRIEF DESCRIPTION OF DRAWINGS

FIG. 1 is a schematic diagram of a structure of an image processing system according to an embodiment of this application;

FIG. 2 is a schematic diagram of internal principles of an encoder 100 and a decoder 200 according to an embodiment of this application;

FIG. 3 is a schematic diagram of typical coding of an $8 \times 8$ polar code according to an embodiment of this application;

FIG. 4 is a schematic diagram of a polarization change according to an embodiment of this application;

FIG. 5 is a schematic diagram of a structure of a feedforward neural network according to an embodiment of this application;

FIG. 6 is a schematic diagram of an operation of each neuron in a neural network according to an embodiment of this application;

FIG. 7 is a schematic flowchart of an image signal processing method according to an embodiment of this application;

FIG. 8 is a schematic diagram of a BSC according to an embodiment of this application;

FIG. 9 is a schematic flowchart of another image signal processing method according to an embodiment of this application;

FIG. 10 is a schematic flowchart of lossless polar compression according to an embodiment of this application;

FIG. 11 is a schematic flowchart of still another image signal processing method according to an embodiment of this application;

FIG. 12 is a schematic diagram of a structure of an image signal processing apparatus according to an embodiment of this application;

FIG. 13 is a schematic diagram of a structure of another image signal processing apparatus according to an embodiment of this application;

FIG. 14 is a schematic diagram of a structure of still another image signal processing apparatus according to an embodiment of this application; and

FIG. 15 is a schematic diagram of a structure of yet another image signal processing apparatus according to an embodiment of this application.

## DESCRIPTION OF EMBODIMENTS

In addition, in the embodiments of this application, the word "example" or "for example" is used to represent giving an example, an illustration, or a description. Any embodiment or design scheme described as "in an example" or "for example" in the embodiments of this application should not be explained as being more preferred or having more advantages than another embodiment or design scheme. Exactly, use of the word such as "example" or "for example" is intended to present a related concept in a specific manner.

This application provides an image signal processing method. Basic principles of the method are as follows: source coding is performed, based on channel polarization characteristics of polar coding (a polar code), by using the polar code to compress a binary source, and only a compressed bit sequence is transmitted to a peer end; and the peer end performs decoding by using an existing polar decoder, to implement fixed-length entropy coding. An entire process is easy to implement, and spreading of decoding errors can be controlled.

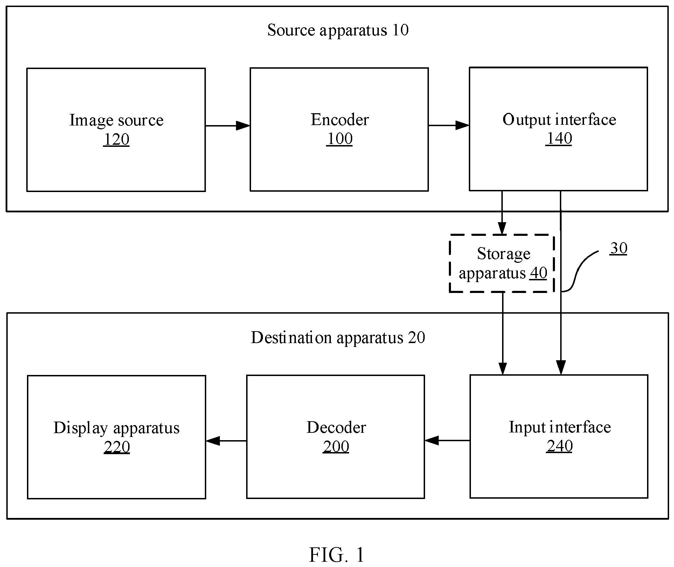

The solution provided in this application may be applied to an image processing system shown in FIG. 1. An image encoder 100 and an image decoder 200 in the image processing system shown in FIG. 1 are configured to perform image compression and decompression according to the image processing method proposed in this application.

As shown in FIG. 1, the image processing system includes a source apparatus 10 and a destination apparatus 20. The source apparatus 10 generates a coded bit sequence. Therefore, the source apparatus 10 may be referred to as an image coding apparatus. The destination apparatus 20 may decode the coded bit sequence generated by the source apparatus 10. Therefore, the destination apparatus 20 may be referred to as a video decoding apparatus. Various implementation solutions of the source apparatus 10, the destination apparatus 20, or both the source apparatus 10 and the destination apparatus 20 may include one or more processors and a memory coupled to the one or more processors. The memory may include but is not limited to a RAM, a ROM, an EEPROM, a flash memory, or any other medium that can be used to store desired program code in a form of an instruction or a data structure accessible by a computer, as described in this specification.

The source apparatus 10 and the destination apparatus 20 may include various apparatuses, including a desktop computer, a mobile computing apparatus, a notebook (for example, laptop) computer, a tablet computer, a set top box, a handheld telephone set such as a "smart" phone, a television set, a camera, a display apparatus, a digital media player, a video game console, an in-vehicle computer, and similar apparatuses.

The destination apparatus 20 may receive the coded bit sequence from the source apparatus 10 through a link 30. The link 30 may include one or more media or apparatuses that can transfer the coded bit sequence from the source apparatus 10 to the destination apparatus 20. In an example, the link 30 may include one or more communication media that enable the source apparatus 10 to directly transmit the coded bit sequence to the destination apparatus 20 in real time. In this example, the source apparatus 10 may modulate the coded bit sequence according to a communication standard (for example, a wireless communication protocol), and may transmit a modulated bit sequence to the destination apparatus 20. The one or more communication media may include a wireless and/or wired communication medium, for example, a radio frequency (radio frequency, RF) spectrum or one or more physical transmission lines. The one or more communication media may constitute a part of a packet-based network, and the packet-based network is, for example, a local area network, a wide area network, or a global network (for example, the Internet). The one or more communication media may include a router, a switch, a base station, or another device facilitating communication from the source apparatus 10 to the destination apparatus 20.

In another example, the coded bit sequence may be output from an output interface 140 to a storage apparatus 40. Similarly, the coded bit sequence may be accessed from the storage apparatus 40 through an input interface 240. The storage apparatus 40 may include any one of a plurality of distributed data storage media or locally accessible data storage media, for example, a hard disk drive, a Blu-ray disc, a digital video disc (digital video disc, DVD), a compact disc read-only memory (compact disc read-only memory, CD-ROM), a flash memory, a volatile or non-volatile memory, or any other appropriate digital storage media configured to store coded video data.

In another example, the storage apparatus 40 may correspond to a file server or another intermediate storage apparatus that can store the coded bit sequence generated by the source apparatus 10. The destination apparatus 20 may access the stored bit sequence from the storage apparatus 40 through streaming or downloading. The file server may be any type of server capable of storing the coded bit sequence and transmitting the coded bit sequence to the destination apparatus 20. An example of the file server includes a network server (which is, for example, used for a website), a file transfer protocol (file transfer protocol, FTP) server, a network attached storage (network attached storage, NAS) apparatus, or a local disk drive. The destination apparatus 20 may access the coded bit sequence through any standard data connection (including an Internet connection). The standard data connection may include a wireless channel (for example, a wireless fidelity (wireless-fidelity, Wi-Fi) connection), a wired connection (for example, a digital subscriber line (digital subscriber line, DSL), or a cable modem), or a combination of a wireless channel and a wired connection, where the combination is suitable for accessing the coded bit sequence stored on the file server. Transmission of the coded bit sequence from the storage apparatus 40 may be streaming transmission, download transmission, or a combination of both.

In the example of FIG. 1, the source apparatus 10 includes an image source 120, the image encoder 100, and the output interface 140. In some examples, the output interface 140 may include a modulator/demodulator (a modem) and/or a transmitter. The image source 120 may include an image capture apparatus (for example, a camera), a video archive including previously captured image data, a feed-in interface for receiving image data from an image content provider, and/or a computer graphics system for generating image data, or a combination of these sources of image data.

The encoder 100 may code image data from the image source 120. In some examples, the source apparatus 10 directly transmits the coded bit sequence to the destination apparatus 20 through the output interface 140. In other examples, the coded bit sequence may also be stored on the storage apparatus 40 for later access by the destination apparatus 20 for decoding.

In the example of FIG. 1, the destination apparatus 20 includes the input interface 240, the decoder 200, and a display apparatus 220. In some examples, the input interface 240 includes a receiver and/or a modem. The input interface 240 may receive the coded bit sequence through the link 30 and/or from the storage apparatus 40. The display apparatus 220 may be integrated with the destination apparatus 20 or may be external to the destination apparatus 20. Generally, the display apparatus 220 displays decoded image data. The display apparatus 220 may include a plurality of types of display apparatuses, for example, a liquid crystal display (liquid crystal display, LCD), a plasma display, an organic light-emitting diode (organic light-emitting diode, OLED) display, or another type of display apparatus.

The encoder 100 and the decoder 200 may each be implemented as any one of a plurality of circuits such as one or more microprocessors, digital signal processors (digital signal processors, DSP), application-specific integrated circuits (application-specific integrated circuits, ASIC), field programmable gate arrays (field programmable gate arrays, FPGA), discrete logics, hardware, or any combination thereof. If this application is implemented partially through software, the apparatus may store, in an appropriate nonvolatile computer-readable storage medium, instructions used for the software, and may use one or more processors to execute instructions in hardware, to implement the technologies in this application. Any one of the foregoing content (including hardware, software, a combination of hardware and software, and the like) may be considered as one or more processors. Each of the encoder 100 and the decoder 200 may be included in one or more encoders or decoders, and any one of the encoder or the decoder may be integrated as a part of a combined encoder/decoder (codec) in a corresponding apparatus.

It should be noted that the image processing system described in FIG. 1 is merely an example, and does not constitute a specific limitation on a structure of the image processing system.

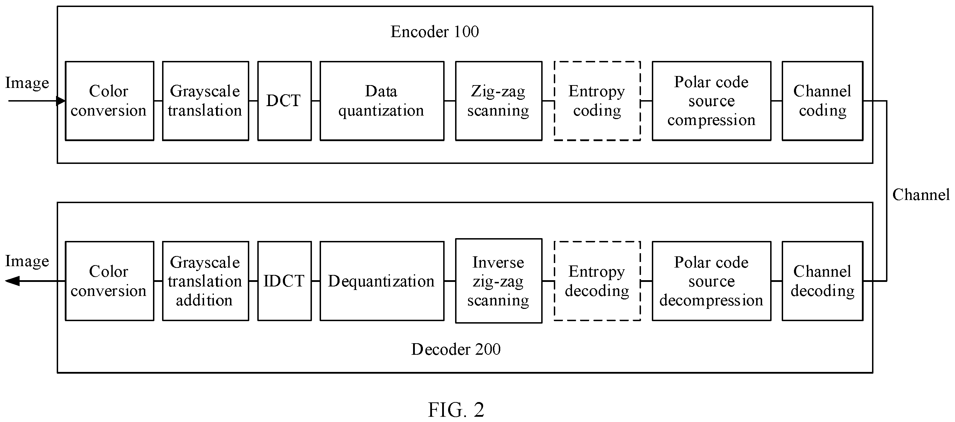

FIG. 2 shows internal principles of the encoder 100 and the decoder 200. As shown in FIG. 2, an image is input to the encoder 100, and undergoes a conventional JPEG operation, for example, color conversion, grayscale translation, DCT, data quantization, zig-zag scanning, and entropy coding (for example, run-length coding, which is an optional operation), to obtain a binary source $X^N$ of the image. Polar code source compression is performed on $X^N$, and appropriate redundancy protection is performed on a compressed bit sequence through channel coding to resist channel noise. A bit sequence obtained through channel coding is transmitted to the decoder 200 through a channel between the encoder 100 and the decoder 200. In the decoder 200, after channel decoding is performed on a received signal, an operation, for example, polar code source decompression, entropy decoding (an optional operation), inverse zig-zag scanning, dequantization, IDCT, grayscale translation addition, and color conversion is performed to restore the image. The solutions of this application are mainly specific to a polar code source compression process and a polar code source decompression process.

Before the specific solutions of this application are described, principles used in the solutions of this application are first described.

First, polar coding (the polar code) is described.

The polar coding is an only known channel coding scheme that can be strictly proved to "meet" a channel capacity, and has characteristics of high performance, low complexity, a flexible matching manner, and the like.

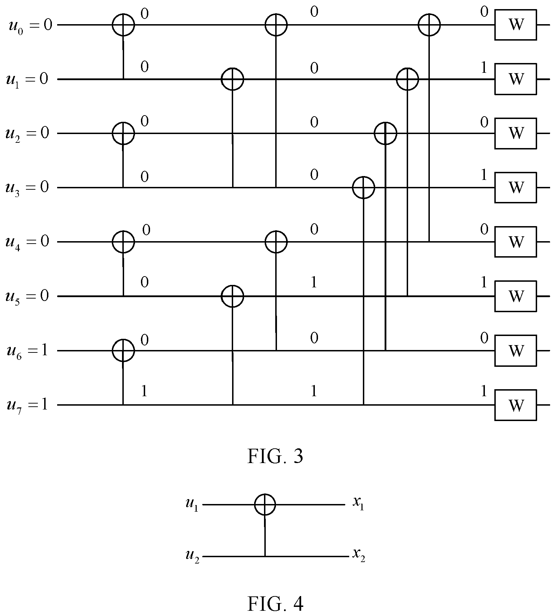

FIG. 3 is a schematic diagram of typical coding of an $8 \times 8$ polar code. To-be-encoded bits are classified into fixed (frozen) bits and information bits (data) based on a sequence of their reliability. A bit with higher reliability is set as an information bit (data), and a bit with lower reliability is set as a fixed (frozen) bit. A value of the fixed (frozen) bit is usually set to 0, which is known to both a transmit end and a receive end in actual transmission. As shown in FIG. 3, $u_7$, $u_6$, $u_5$, and $u_3$ are four bits whose reliability is ranked top, and are set to information bits (data); and $u_4$, $u_2$, $u_1$, and $u_0$ are four bits whose reliability is ranked low, and are set to fixed (frozen) bits.

Then, a source entropy polarization theory is described.

It is assumed that the source $X^N$ conforms to Bernoulli (Bernoulli) distribution Ber(p), and it can be learned that a source entropy is as follows:

$$H(x) = (1-p)\log\frac{1}{1-p} + p\log\frac{1}{p}$$

, and $0 \leq H(x) \leq 1$.

FIG. 4 is a schematic diagram of polar code source polarization. It can be learned from a relationship shown in FIG. 4 that $(u_1, u_2)$ and $(x_1, x_2)$ are one-to-one mapped. Therefore, it can be learned that $H(u_1, u_2) = H(x_1, x_2)$.

Because a polarization matrix is an invertible matrix, an entropy sum obtained after the polarization operation remains unchanged, that is, $H(u_1, u_2) = H(u_1) + H(u_2|u_1) = 2H(x)$. Because $U_2 = X_2$, $H(u_2|u_1) \leq H(x)$.

Because the entropy sum remains unchanged, it can be learned that $H(u_1) \geq H(x)$.

It can be seen from the foregoing derivation that, from x to u, a polarization phenomenon occurs after source entropies of discrete sources change through polarization shown in FIG. 4. To be specific, $H(u_2|u_1)$ becomes smaller than $H(x)$, and $H(u_1)$ becomes greater than $H(x)$. Therefore, after a polarization change structure is extended, and after a plurality of independently and identically distributed sources $x_1^N$ undergo a polarization change, source entropies of some sources approximate 1, in other words, average uncertainty of the sources increases; and source entropies of the other sources approximate 0, in other words, average uncertainty of the sources decreases. A polarization process of the sources is completed. The process may be expressed as:

$$H(u_1^N) = H(x_1^N) = H(u_1) + H(u_2|u_1) + \cdots + H(u_i|u_1^{i-1}) + \cdots + H(u_N|u_1^{N-1}),$$

where $H(u_i|u_1^{i-1})$ tends to a fixed value (0 or 1) with a probability P = 1, that is,

$$\frac{H(u_i|u_1^{i-1})\to 1}{N} = H(x);$$

and

$$\frac{H(u_i|u_1^{i-1})\to 0}{N} = 1 - H(x).$$

Finally, a neural network (neural network, NN) is described.

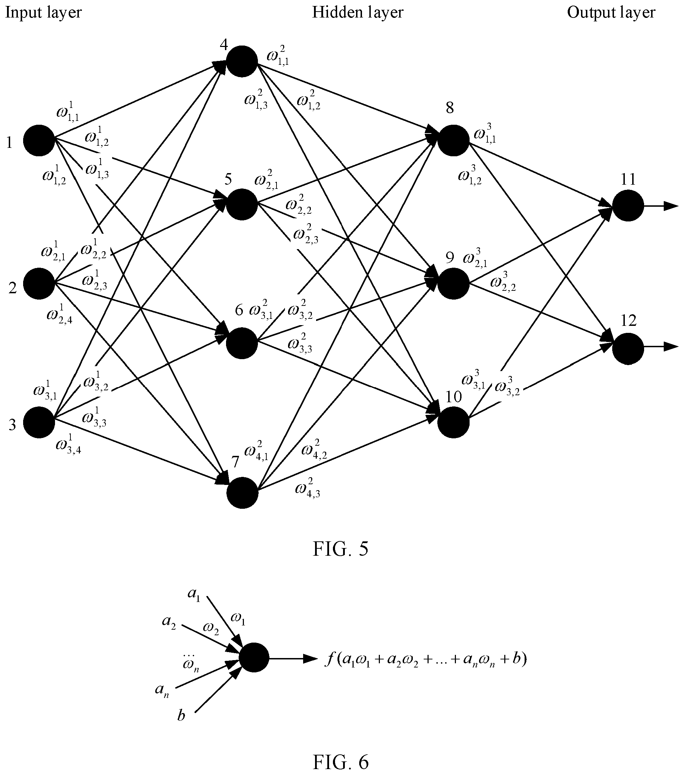

FIG. 5 is a schematic diagram of a structure of a feedforward neural network. The leftmost of the network is an input layer, the middle of the network is a hidden layer, and the rightmost of the network is an output layer.

The neural network includes a plurality of neurons. An operation of each neuron is shown in FIG. 6, where $a_1$, $a_2$, ... , $a_n$ represent n inputs of the neuron, $\omega_1$, $\omega_2$, ... , $\omega_n$ represent weights on corresponding connection lines, b is an offset, and f(-) represents an activation function. It can be learned that a function of a neuron is to sum up products of input values and weights, and obtain a corresponding output value by using a non-linear function. To be specific, after linear transformation is performed on neurons at each layer of the neural network, a nonlinear excitation function (activation function) is added to convert a linear result. After the linear result is converted by the plurality of layers of the neural network, a finally obtained output is a complex nonlinear function.

After the nonlinear excitation function is added, the neural network does not use complex linear combination to approximate a smooth curve to divide a plane, but can possibly directly learn the smooth curve to divide the plane, which is a reason why the activation function is described. Common activation functions in the neural network include sigmoid, ReLU, tanh, and the like. In actual application, flexible configuration may be performed based on advantages and disadvantages of activation functions:

$$\text{the sigmoid function: } f(z) = \frac{1}{1+exp(-z)};$$

$$\text{the ReLU function: } f(z) = \max(0, z);$$

and

$$\text{the tanh function: } f(z) = tanh(z) = \frac{e^z - e^{-z}}{e^z + e^{-z}}.$$

A process in which training data is input into the neural network, passes through the hidden layer, and reaches the output layer, and an output result is obtained is a forward propagation process of the neural network. Because there is a specific error between the output result of the NN and an actual result, an error between an estimated value and an actual value can be calculated (by using a cost function), and the error can be propagated back from the output layer to the hidden layer until the error reaches the input layer. In a back propagation process, a weight of each neuron in the neural network is adjusted based on the error, the foregoing process is continuously iterated until the neural network converges, and a finally obtained weight is an optimal weight. A back propagation (back propagation, BP) algorithm is an optimization algorithm based on gradient descent, which is often used in training an artificial neural network.

The cost function may include a minimum mean square error (MSE), cross entropy (cross entropy), or the like.

Specifically, a process of the gradient descent and the back propagation (BP) algorithm is described herein.

A gradient descent algorithm is a method for a neural network to update a weight based on a network error. A gradient is a vector in a direction in which a function value increases the fastest, and a reverse direction of the gradient is a direction in which the function value decreases the fastest. The weight is modified and updated along the reverse direction of the gradient. After a plurality of rounds of iteration, a value of the weight when the cost function has the minimum value is found.

The back propagation algorithm (BP algorithm) starts from the output layer, calculates an error vector backward, updates weights from the output layer to the input layer layer by layer, and iterates the above process for a plurality of times. A core mathematical tool is a chain derivative rule of calculus. That the MSE is the cost function and the sigmoid function is the activation function is used as an example, and mathematical derivation of a weight update formula in the BP algorithm is given below:

A training set (x, y) is given; if it is assumed that an output of the neural network is y = $(y_1, y_2, \ldots, y_1)$, a mean square error of the sample is $E = \frac{1}{2}\sum_{i=1}^{l}(t_i - y_i)^2$ , where $t_i$ is a target value of the sample corresponding to a node i.

It is assumed that $net_j$ is a weighted input of a node j, that is, $net_j = \vec{\omega_j}\vec{x_j} = \Sigma_i\omega_{ji}x_{ji}$; and E is a function of $net_j$, but $net_j$ is a function of $\omega_{ji}$. According to the chain derivative rule, it can be learned that: $\frac{\partial E}{\partial \omega_{ji}} = \frac{\partial E}{\partial net_j}\frac{\partial net_j}{\partial \omega_{ji}} = \frac{\partial E}{\partial net_j}\frac{\partial \Sigma_i \omega_{ji} x_{ji}}{\partial \omega_{ji}} = \frac{\partial E}{\partial net_j}x_{ji}$ , where $x_{ji}$ represents an input value transferred by the node i to the node j. For $\frac{\partial E}{\partial net_j}$ , there are two types of cases: a case for the output layer and a case for the hidden layer.

For the output layer: $\frac{\partial E}{\partial net_j} = \frac{\partial E}{\partial y_j}\frac{\partial y_j}{\partial net_j}$ , where $\frac{\partial E}{\partial y_j} = \frac{\partial\frac{1}{2}\Sigma_{i=1}^{l}(t_i - y_i)^2}{\partial y_j} = \frac{\partial\frac{1}{2}(t_j - y_j)^2}{\partial y_j} = -(t_j - y_j)$ , and $\frac{\partial y_j}{\partial net_j} = \frac{\partial\alpha_j}{\partial net_j} = y_j(1 - y_j)$ .

Because $\alpha_j = sigmoid(net_j) = \frac{1}{1+e^{-net_j}}$ for the output layer, it can be learned that: $\frac{\partial E}{\partial net_j} = \delta_j = -\frac{\partial E}{\partial net_j}$ is set, to be specific, an error term $\delta$ of a node is an inverse value of the network error to a partial derivative input by the node. $\delta_j = -\frac{\partial E}{\partial net_j}$ is input into the above formula, and it can be learned that: $\delta_j = (t_j - y_j)y_j(1 - y_j)$.

For the hidden layer: A set $\varphi_j$ of all downstream nodes of the node j is defined (for example, as shown in FIG. 5, downstream nodes of a node 8 are a node 11 and a node 12). It can be learned from the structure of the neural network that $net_j$ can only affect $\varphi_j$ by affecting E. If it is assumed that $net_k$ is an input of the downstream node of the node j, E is a function of $net_j$. There are a plurality of $net_j$, and a full derivative formula is used. Therefore, it can be learned that:

$$\frac{\partial E}{\partial net_j} = \sum_{k\in\varphi_j}\frac{\partial E}{\partial net_k}\frac{\partial net_k}{\partial net_j}$$

$$= \sum_{k\in\varphi_j}-\delta_k\frac{\partial net_k}{\partial net_j}$$

$$= \sum_{k\in\varphi_j}-\delta_k\frac{\partial net_k}{\partial\alpha_j}\frac{\partial\alpha_j}{\partial net_j}$$

$$= \sum_{k\in\varphi_j}-\delta_k\,\omega_{kj}\frac{\partial\alpha_j}{\partial net_j}$$

$$= \sum_{k\in\varphi_j}-\delta_k\,\omega_{kj}\alpha_j(1 - \alpha_j)$$

$$= -\alpha_j(1 - \alpha_j)\Sigma_{k\in\varphi_j}\delta_k\omega_{kj}.$$

Because $\delta_j = -\frac{\partial E}{\partial net_j}$ , and when $\delta_j = -\frac{\partial E}{\partial net_j}$ is input into the foregoing formula, it can be learned that: $\delta_j = a_j(1 - \alpha_j) \sum_{k \in \varphi_j} \delta_k \omega_{kj}$.

$\delta_j$ is an error term of the node j, $\delta_k$ is an error term of a node k, and $\alpha_j = \mathrm{sigmoid}(net_j) = \frac{1}{1+e^{-net_j}}$ , namely, an output value of the node j.

In conclusion, it can be learned that: for the output layer, $\delta_j = (t_j - y_j)y_j(1 - y_j)$; and for the hidden layer: $\delta_j = \alpha_j(1 - \alpha_j) \sum_{k \in \varphi_j} \delta_k \omega_{kj}$.

The weight update formula is as follows: $\omega_{ji} = \omega_{ji} + \eta \delta_j x_{ji}$, where $\eta$ is a learning rate.

It can be learned from the above derivation that the gradient is 7= 8x (where $\delta$ is a negative number for a product of derivative of the error term and the activation function). Therefore, the weight update formula may be summarized as: $\omega = \omega + \eta \nabla$.

It can be understood from the foregoing process that the reverse direction of the gradient (a reason why the negative number is taken for $\delta$) is the direction in which the function value decreases the fastest. Therefore, when $\omega$ is modified along the reverse direction of the gradient and after a plurality of rounds of iterative updates, a value of $\omega$ when the cost function has the minimum value is found, in other words, when the neural network converges.

The following describes the technical solutions of this application in detail with reference to the accompanying drawings.

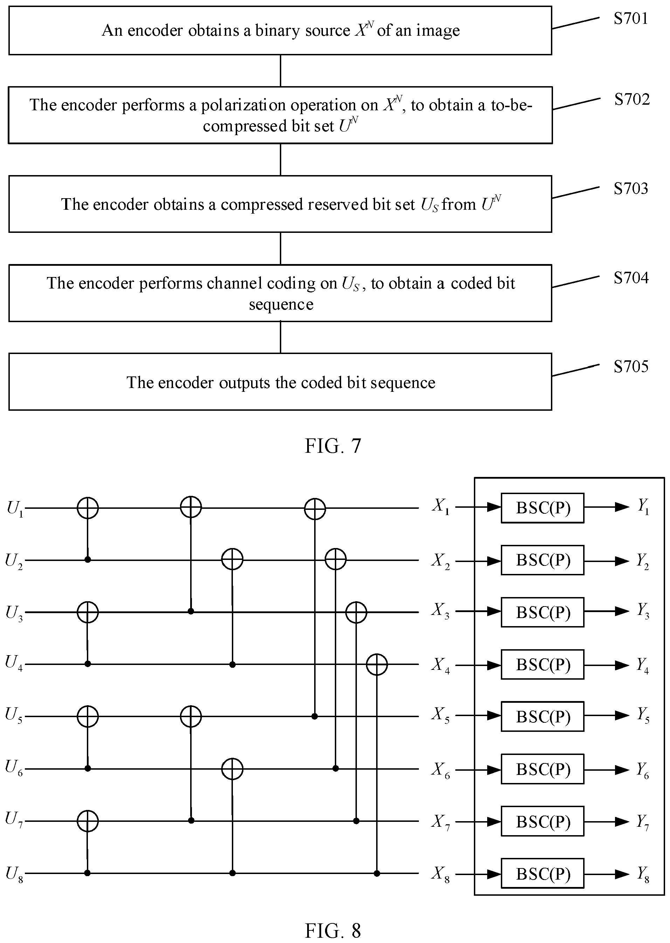

According to one aspect, an embodiment of this application provides an image signal processing method. As shown in FIG. 7, the method may include the following steps.

S701: An encoder obtains a binary source $X^N$ of an image.

Specifically, when obtaining the image, the encoder performs a conventional JPEG operation on the image, for example, color conversion, grayscale translation, DCT, data quantization, zig-zag scanning, and entropy coding (for example, run-length coding, which is an optional operation), to obtain the binary source $X^N$ of the image. This process is not described in this application.

S702: The encoder performs a polarization operation on $X^N$, to obtain a to-be-compressed bit set $UN$.

Specifically, that the encoder performs a polarization operation on $X^N$ in S702 may specifically include: multiplying $X^N$ by a generator matrix $G$ (which may also be referred to as a polarization matrix) of polar coding (a polar code), to obtain $U^N$. That is, $U^N = X^N G$.

Content of $G$ may be configured based on an actual requirement. This is not specifically limited in this embodiment of this application.

In this way, compression of the signal $X^N$ is converted to compression of $U^N$. Based on the foregoing characteristics of source entropy polarization, because some bits $H(U_i|U_1^{i-1}) = 0$ in $U^N$ (namely, bits with low uncertainty) may be completely determined by other bits $U_1^{i-1}$, these bits may be discarded during compression. Only some bits $H(U_i|U_1^{i-1}) = 1$ (namely, bits with high uncertainty) need to be reserved. $S = \{i \in [N]: H(U_i|U_1^{i-1}) \to 1\}$ is set, and a sequence U corresponding to the set is recorded as $U_S$ and is used as a set of the bits reserved during compression. The set is referred to as a compressed reserved bit set. A complementary set of S is $S^c$, and a sequence U corresponding to the set is recorded as $U_{Sc}$ and is used as a set of the bits discarded during compression. The set is referred to as a compressed discarded bit set. That is, $U^N = [U_S, U_{Sc}]$.

S703: The encoder obtains the compressed reserved bit set $U_S$ from $U^N$.

A bit in $U_S$ is a reserved bit during source compression, and $U_S$ are some bits in $U^N$.

Optionally, a source entropy of the bit in $U_S$ approximates 1; or a source entropy of the bit in $U_S$ tends to be greater than or equal to a first preset threshold; or a Bhattacharyya parameter of an equivalent channel corresponding to the bit in $U_S$ is greater than or equal to a second preset threshold; or a channel capacity of an equivalent channel corresponding to the bit in $U_S$ is less than or equal to a third preset threshold.

Values of the first preset threshold, the second preset threshold, and the third preset threshold may be configured based on an actual requirement.

Specifically, the encoder may implement S703 by using but is not limited to any one of the following two solutions: Solution 1: The encoder equates a source problem to a channel problem.

Specifically, polar code compression design for a source conforming to Bernoulli distribution Ber(p) may be equivalent to polar channel decoding design for a BSC. Fixed bits $U_F$ of an equivalent channel are used as $U_S$ (that is, $U_F \leftrightarrow U_S$), and information bits $U_I$ of the equivalent channel are used as $U_{SC}$ (that is, $U_I \leftrightarrow U_{Sc}$).

FIG. 8 is a schematic diagram of a BSC according to an embodiment of this application. Noise distribution of the BSC is the same as that of the source. Therefore, a channel capacity of BSC (q) can be calculated as $1 - H(q) = 1 + q \log_2 q + (1 - q) \log_2 (1 - q)$, which is complementary to H(q).

Specifically, W = BSC(q) and n = $\log_2$ N are set, and N polarized channels on which n times of polarization are performed are represented by {i $\in$ [N], $W_N^{(i)}$ }. It may be theoretically proved that capacities of these polarized channels are complementary to the foregoing polarized source entropies, that is, $I\left(W_N^{(i)}\right) = 1 - H(U_i | U_1^{i-1})$ . A specific proof process is not described again.

In solution 1 of S703, when source coding is equivalent to channel decoding, channel reliability ranking may be used during channel decoding. Bits corresponding to equivalent channel reliability ranked low in $U^N$ are used as $U_S$ based on a sequence of equivalent channel reliability in descending order. A higher source entropy of a source bit indicates lower reliability of an equivalent channel corresponding to the source bit.

In solution 1 of S703, the fixed bits $U_F$ of the equivalent channel are used as $U_S$ (that is, $U_F \leftrightarrow U_S$), and the information bits $U_I$ of the equivalent channel are used as $U_{SC}$.

Specifically, a quantity of bits in $U_S$ depends on an expected compression rate. This is not specifically limited in this embodiment of this application.

A channel reliability ranking method used during channel coding may use an existing Gaussian approximation (Gaussian Approximation) algorithm, a channel degradation and upgradation merging (channel degradation and upgradation merging) algorithm, some ranking methods, or the like. Details are not described in this embodiment of this application.

Solution 2: The encoder calculates a source entropy of each bit in $U^N$, and uses bits whose source entropies approximate 1 in $U^N$ as $U_S$.

A process of calculating the source entropies may be implemented through mathematical derivation. Details are not described in this embodiment of this application.

S704: The encoder performs channel coding on $U_S$ , to obtain a coded bit sequence.

In S704, a channel coding manner such as SC decoding, SCL decoding, or BP decoding may be used, or another channel coding manner may be used. A channel coding process in S704 is not limited in this application.

S705: The encoder outputs the coded bit sequence.

Specifically, in S705, the encoder sends the bit sequence coded in S704 to a channel for transmission.

According to the image signal processing method provided in this application, the binary source is compressed through polar coding, and fixed-length source coding is implemented based on the expected compression rate. This process is easy to implement. In addition, a coding granularity of the polar coding is an image block (block). Even if a decoding error occurs, the error spreads only in the block, thereby effectively controlling error spreading at a decoder, and improving image compression performance.

Further, $U^N$ further includes the compressed discarded bit set $U_{SC}$ obtained through polar code source coding. Therefore, during source coding, $U_{SC}$ is discarded and is not transmitted, and the decoder may decode content of the compressed discarded bit set based on other bits.

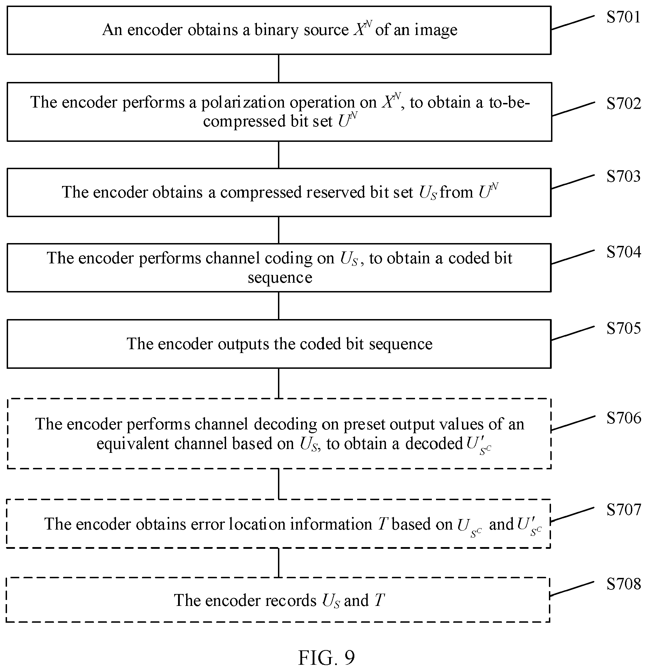

Further, during source coding, $U_{SC}$ is discarded and not transmitted. To implement lossless compression, an error location obtained when the encoder obtains $U_{SC}$ is recorded, and the decoder flips a bit in the error location during decoding, to implement lossless compression and decompression. As shown in FIG. 9, based on FIG. 7, the image processing method provided in this embodiment of this application further includes S706 and S707.

S706: The encoder performs channel decoding on preset output values of the equivalent channel based on $U_S$ , to obtain a decoded $U'_{S^C}$ . $U'_{S^C}$ is decoded estimated values of $U_{SC}$.

Specifically, in S706, a process of performing source coding on the binary Bernoulli source is equivalent to a channel decoding process of the BSC. One BSC is visualized. It is assumed that a received signal of the polar code decoder is $Y^N = 0^N$ (the preset output values of the equivalent channel are preconfigured, or may be other values other than 0); and it is assumed that frozen bits (the fixed bits) of the equivalent channel are $U_S$ , $\hat{U}^N$ (a decoding result of the channel) is obtained by using the polar channel decoder based on $U_S$ and $Y^N$. The frozen bits remain unchanged, and bits in $\hat{U}^N$ other than $U_S$ are $U'_{S^C}$ .

It should be noted that, in an actual implementation process, one BSC described in this application is visualized by using the existing polar code decoder to perform channel decoding. An SC decoder is used as an example. $f^{SC}(\blacksquare)$ is set to an SC decoding function of the polar code, and $U_I = f^{SC}(Y^N = 0^N, U_S)$.

$U_S$ is a vector that is not 0, which is different from that of the existing decoder. The following linear transformation may be performed, and $Z^N$ is set to be a noise vector of the BSC:

$$X^N + Z^N = Y^N = 0^N;$$

$$U^N G + Z^N = Y^N = 0^N;$$

$$[U_F, U_I]G + Z^N = Y^N = 0^N;$$

and

$$[0_F, U_I]G + Z^N = Y^N = [U_F, 0_I]G.$$

It is equivalent to $U_I = f^{SC}(Y^N = [U_F, 0_I]G, U_F = 0_F)$. In this way, lossless source compression of the polar code can be directly implemented by directly using the existing decoder.

S707: The encoder obtains error location information $T$ based on $U_{SC}$ and $U'_{S^C}$ .

In S707, $U'_{S^C}$ obtained through decoding and original $U'_{S^C}$ are compared to find location sequence numbers of different bits, and the numbers are recorded as $T$.

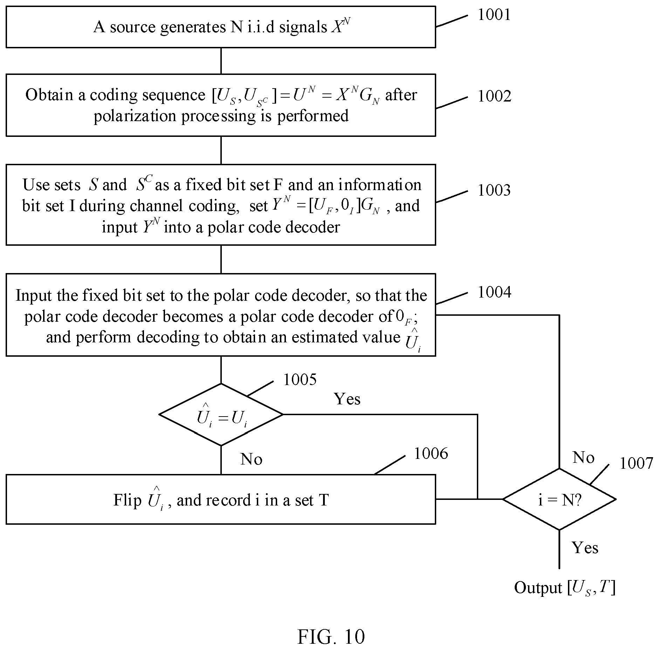

For example, FIG. 10 is a schematic flowchart of lossless polar compression according to an embodiment of this application. As shown in FIG. 10, a process may include: S1001: The source generates N independently and identically distributed (independently and identically distributed, i.i.d) signals $X^N$. S1002: Obtain a to-be-compressed bit set $[U_S, U_{SC}] = U^N = X^N G$ after the polarization operation is performed, where $G$ is a polarization matrix. S1003: Use sets $S$ and $S^C$ as a fixed bit set F and an information bit set I during channel coding, set $Y^N = [U_F, 0_I]G$ , and input $Y^N$ into a standard polar code decoder. S1004: Input the fixed bit set to the polar code decoder, so that the polar code decoder becomes a polar code decoder of $0_F$ ; and perform decoding to obtain an estimated value $\hat{U}_i$ , where $i \in I$. S1005: Determine whether $\hat{U}_i = U_i$ is met; and if $\hat{U}_i = U_i$ is not met, perform S1006, or if $\hat{U}_i = U_i$ is met, perform 1007. S1006: Flip $\hat{U}_i$ , and record $i$ in a set T. S1007: Determine whether $i$ is equal to N; and if $i$ is equal to N, output $[U_S, T]$, or if $i$ is not equal to N, check a next bit.

In a possible implementation not forming part of the claimed invention, S704 is performed after S707, and the encoder performs channel coding on $U_S$ and $T$ in S704, to obtain the coded bit sequence.
It should be noted that before channel coding is performed on $T$, $T$ further needs to be converted into a binary form.
In the embodiment of the claimed invention, S708 is performed after S707, to train a neural network for predicting the error location information $T$ by the decoder.
S708: The encoder records $U_S$ and $T$.
$U_S$ and $T$ recorded in S708 are used as a group of data, and are used to train the preset neural network for predicting the error location information. The preset neural network is a neural network that is trained based on M groups of compressed reserved bit sets and error location information obtained through polar code source coding until the neural network converges.
It should be noted that the neural network may be trained offline until the neural network converges based on the M groups of compressed reserved bit sets and error location information obtained through polar code source coding, to obtain the preset neural network. The preset neural network is configured in the decoder for predicting $T$ during decoding. The M groups of compressed reserved bit sets and error location information obtained through polar code source coding may be obtained through learning, or may be obtained by executing an image processing process. This is not specifically limited in this embodiment of this application.
For a neural network training method, refer to the foregoing BP algorithm or another training method. This is also not specifically limited in this embodiment of this application. A process of training a model is a process of optimizing a cost function.
During training, all stored $[U_S, T]$ are used as training samples, and are sent to a neural network whose input layer node quantity is length $(U_S)$ and output layer node quantity is a length of $T$ for training. $U_S^j$ is an input to an input layer of the neural network in each time of training, and $T^j$ is a corresponding expected output value. Because sizes of $T$ corresponding to each $U_F$ may be different, a value with the largest size in all $Ts$ may be selected as an output size of the neural network, or a fixed value may be set as an output size of the neural network. A cost function of the neural network is expressed as: $e = \frac{1}{2}(T^j - \tilde{T}$ , , where $\tilde{T}$ , where $\tilde{T}$ represents an actual output of the neural network. Predicted data obtained at an output layer is compared with a corresponding $T$, and an error value $\ell$ between an expected output and an actual output is obtained by using the cost function. After I times of iterative training are performed by using a back propagation algorithm (BP), weights on connection lines of the neural network are updated for a plurality of times, and e reaches a minimum value that tends to be stable. That is, the neural network tends to converge, and a weight on a current connection line is a final weight.

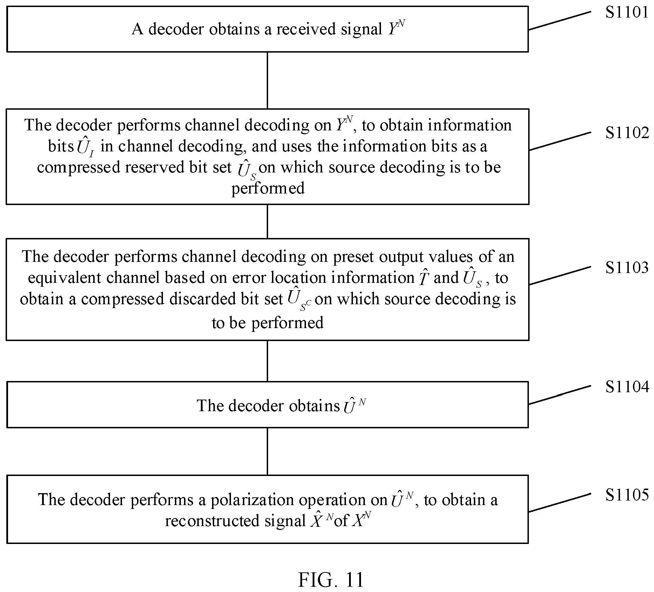

According to another aspect, an embodiment of this application provides another image signal processing method, where the method is applied to the decoder. As shown in FIG. 11, the method includes the following steps: S1101: The decoder obtains the received signal $Y^N$.

$Y^N$ is a signal received by the decoder from the channel, and $Y^N$ is a signal obtained after a bit sequence that is obtained after source coding and channel coding are performed on the binary source $X^N$ of the image is transmitted through the channel.

For example, $Y^N$ may be a signal obtained after the coded bit sequence output by the decoder is transmitted through the channel in S705.

S1102: The decoder performs channel decoding on $Y^N$, to obtain the information bits $\hat{U}_I$ in channel decoding, and uses the information bits as the compressed reserved bit set $\hat{U}_S$ on which source decoding is to be performed.

A channel decoding manner, for example, SC decoding, SCL decoding, or BP decoding may be used in S1102. A channel decoding process in S1102 is not limited in this application, provided that the channel decoding process corresponds to a channel coding manner of the encoder.

51103: The decoder performs channel decoding on the preset output values of the equivalent channel based on the error location information $\hat{T}$ and $\hat{U}_S$, to obtain the compressed discarded bit set $\hat{U}_{SC}$ on which source decoding is to be performed.

$\hat{T}$ indicates a location of a flipped bit during channel decoding.

Specifically, in S1103, the decoder may first obtain the error location information $\hat{T}$. An obtaining process according to the claimed invention includes the following Process 1, whereas the following Process 2 depending on whether the encoder transmits the error location information does not fall under the scope of the claimed invention.

Process 1: The decoder inputs $\hat{U}_S$ into the preset neural network, to obtain the error location information $\hat{T}$ through prediction. The preset neural network is the neural network that is trained based on the M groups of compressed reserved bit sets and error location information obtained through polar code source coding until the neural network converges. The preset neural network has been described in detail in the foregoing content, and details are not described herein again.

Process 2: The encoder transmits the error location information, and the decoder may obtain $\hat{T}$ by performing channel decoding on $Y^N$ in S1102.

Specifically, in S1103, the decoder equates source decoding to polar code channel decoding, and visualizes one BSC. It is assumed that the received signal of the channel is $Y^N = 0^N$ (the preset output values of the equivalent channel are preconfigured, or may be other values); and it is assumed that the frozen bits (the fixed bits) of the equivalent channel are $\hat{U}_S$ , $\hat{U}_{SC}$ (the decoding result of the channel) may be obtained by inputting $Y^N$ into the polar channel decoder for channel decoding, and flipping the bit at an indication location of $\hat{T}$ during decoding.

S1104: The decoder obtains $\hat{U}^N$.

$\hat{U}^N$ includes $\hat{U}_S$ obtained in S1102 and $\hat{U}_{SC}$ obtained in S1103. Specifically, in S1104, the decoder forms $\hat{U}_S$ and $\hat{U}_{SC}$ into $\hat{U}^N$ based on a bit location sequence.

S1105: The decoder performs the polarization operation on $\hat{U}^N$, to obtain a reconstructed signal $\hat{X}^N$ of $X^N$ .

The polarization operation includes multiplying a generation matrix of the polar code.

Further, the decoder may further perform an operation, for example, entropy decoding (which is an optional operation), inverse zig-zag scanning, dequantization, IDCT, grayscale translation addition, and color conversion on $\hat{X}^N$, to restore the image.

According to the image signal processing method provided in this application, corresponding decoding is performed, based on the error location information, on the signal that is compressed through polar coding, to implement lossless compression of the image signal. This process is easy to implement. In addition, a coding granularity of the polar coding is an image block (block). Even if a decoding error occurs, the error spreads only in the block, thereby effectively controlling error spreading at the decoder, and improving image compression performance.

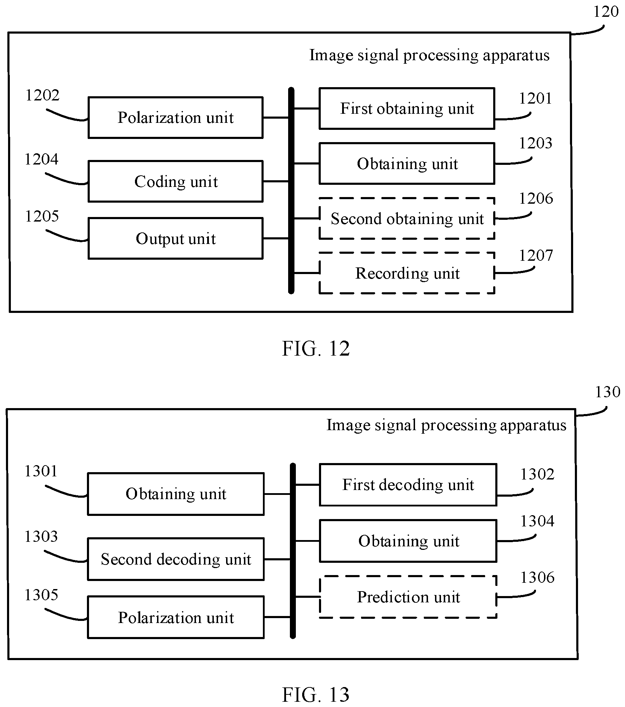

According to another aspect, an embodiment of this application provides an image signal processing apparatus 120. The apparatus 120 may be an encoder, or may be an apparatus or a chip system in an encoder. The image signal processing apparatus 120 may implement functions of the encoder in the foregoing method embodiments; and the functions may be implemented through hardware, or may be implemented through hardware executing corresponding software. The hardware or the software includes one or more modules corresponding to the functions. As shown in FIG. 12, the image signal processing apparatus 120 may include a first obtaining unit 1201, a polarization unit 1202, an obtaining unit 1203, a coding unit 1204, and an output unit 1205.

The first obtaining unit 1201 is configured to obtain a binary source $X^N$ of an image.

The polarization unit 1202 is configured to perform a polarization operation on $X^N$ obtained by the first obtaining unit 1201, to obtain a to-be-compressed bit set $U^N$.

The obtaining unit 1203 is configured to obtain a compressed reserved bit set $U_S$ from $U^N$ obtained by the polarization unit 1202.

The coding unit 1204 is configured to perform channel coding on $U_S$ obtained by the obtaining unit 1203, to obtain a coded bit sequence.

The output unit 1205 is configured to output the coded bit sequence obtained by the coding unit 1204.

The obtaining unit 1203 is specifically configured to: use, based on a sequence of equivalent channel reliability in descending order, bits corresponding to equivalent channel reliability ranked low in $U^N$ as $U_S$. A higher source entropy of a source bit indicates lower reliability of an equivalent channel corresponding to the source bit.

$U^N$ further includes a compressed discarded bit set $U_{SC}$ obtained through polar code source coding. As shown in FIG. 12, the image signal processing apparatus 120 may further include a second obtaining unit 1206, configured to:

perform channel decoding on preset output values of an equivalent channel based on $U_S$, to obtain a decoded $U'_{S^C}$ ;

and obtain error location information $T$ based on $U_{SC}$ and $U'_{S^C}$ ; and a recording unit 1207, configured to record $U_S$ and $T$, to train a neural network for predicting the error location information. The preset neural network is a neural network that is trained based on M groups of compressed reserved bit sets and error location information obtained through polar code source coding until the neural network converges.

In an example not forming part of the claimed invention, the coding unit 1204 may be specifically configured to perform channel coding on $U_S$ and $T$.

According to another aspect, an embodiment of this application provides an image signal processing apparatus 130. The apparatus 130 may be a decoder, or may be an apparatus or a chip system in a decoder. The image signal processing apparatus 130 may implement the functions of the decoder in the foregoing method embodiments; and the functions may be implemented through hardware, or may be implemented through hardware executing corresponding software. The hardware or the software includes one or more modules corresponding to the functions. As shown in FIG. 13, the image signal processing apparatus 130 may include an obtaining unit 1301, a first decoding unit 1302, a second decoding unit 1303, an obtaining unit 1304, and a polarization unit 1305.

The obtaining unit 1301 is configured to obtain a received signal $Y^N$, where $Y^N$ is a signal obtained after a bit sequence that is obtained after source coding and channel coding are performed on a binary source $X^N$ of an image is transmitted through a channel.

The first decoding unit 1302 is configured to: perform channel decoding on $Y^N$ obtained by the obtaining unit 1301, to obtain information bits $\hat{U}_I$ in channel decoding; and use the information bits as a compressed reserved bit set $\hat{U}_S$ on which source decoding is to be performed.

The second decoding unit 1303 is configured to perform channel decoding on preset output values of an equivalent channel based on error location information $\hat{T}$ and $\hat{U}_S$, to obtain a compressed discarded bit set $\hat{U}_{SC}$ on which source decoding is to be performed. $\hat{T}$ indicates a location of a flipped bit during channel decoding.

The obtaining unit 1304 is configured to obtain $\hat{U}^N$, where $\hat{U}^N$ includes $\hat{U}_S$ obtained by the first decoding unit 1302 and $\hat{U}_{SC}$ obtained by the second decoding unit 1303.

The polarization unit 1305 is configured to: perform a polarization operation on $\hat{U}^N$ obtained by the obtaining unit 1304, to obtain a reconstructed signal $\hat{X}^N$ of $X^N$.

Further, as shown in FIG. 13, the image signal processing apparatus 130 further includes a prediction unit 1306, configured to input $\hat{U}_S$ into a preset neural network, to obtain the error location information $\hat{T}$ through prediction. The preset neural network is a neural network that is trained based on M groups of compressed reserved bit sets and error location information obtained through polar code source coding until the neural network converges.

In an example not falling under the scope of the claimed invention, $Y^N$ includes the error location information $\hat{T}$, and the first decoding unit 1302 may be specifically configured to perform channel decoding on $Y^N$, to obtain $\hat{U}_I$ and $\hat{T}$.

In the image signal processing apparatus 120 or the image signal processing apparatus 130 in the embodiments of this application, some units (or components) may be implemented through a hardware circuit, and other units (or devices) may be implemented through software; or all the units (or components) may be implemented through a hardware circuit; or all the units (or components) may be implemented through software.

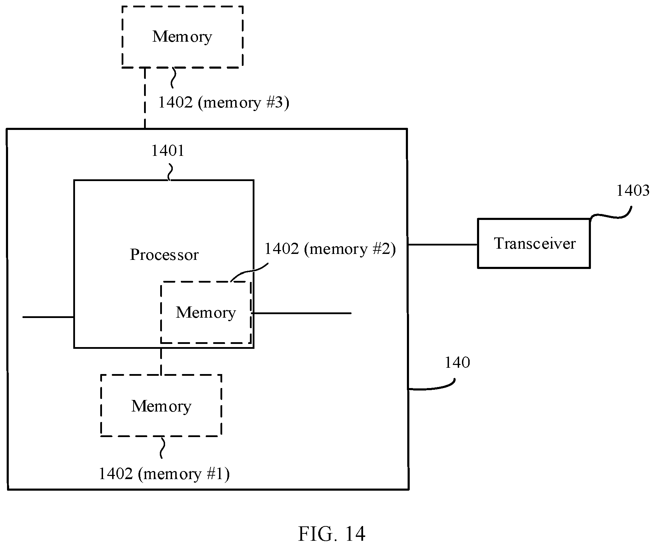

FIG. 14 is a schematic diagram of a structure of an encoder 140 according to an embodiment of this application. As shown in FIG. 14, the encoder 140 includes a processor 1401 and a memory 1402. The memory 1402 may be independent of the processor or independent of the device (a memory #3). The memory 1402 may alternatively be inside the processor or the device (a memory #1 and a memory #2). The memory 1402 may be a physically independent unit, or may be storage space, a network hard disk, or the like on a cloud server.

The memory 1402 is configured to store computer-readable instructions (or referred to as computer programs).

The processor 1401 is configured to read the computer-readable instructions to implement the method provided in any one of the foregoing aspects related to the encoder and any implementation of the aspects.

Optionally, the memory 1402 (the memory (memory) #1) is located inside the encoder 140.

Optionally, the memory 1402 (the memory (memory) #2) is integrated with the processor.

Optionally, the memory 1402 (the memory (memory) #3) is located outside the encoder 140.

Optionally, the encoder 140 further includes a transceiver 1403, configured to receive and send data.

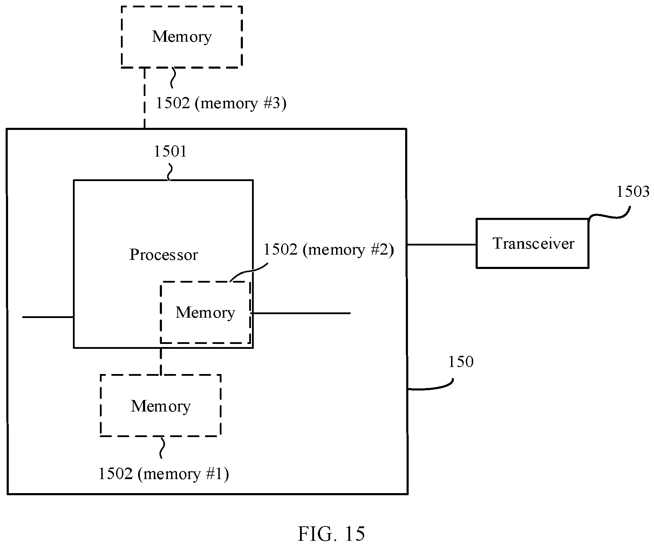

FIG. 15 is a schematic diagram of a structure of a decoder 150 according to an embodiment of this application. As shown in FIG. 15, the decoder 150 includes a processor 1501 and a memory 1502. The memory 1502 may be independent of the processor or independent of the device (a memory #3). The memory 1502 may alternatively be inside the processor or the device (a memory #1 and a memory #2). The memory 1502 may be a physically independent unit, or may be storage space, a network hard disk, or the like on a cloud server.

The memory 1502 is configured to store computer-readable instructions (or referred to as computer programs).

The processor 1501 is configured to read the computer-readable instructions to implement the method provided in any one of the foregoing aspects related to the decoder and any implementation of the aspects.

Optionally, the memory 1502 (the memory (memory) #1) is located inside the decoder 150.

Optionally, the memory 1502 (the memory (memory) #2) is integrated with the processor.

Optionally, the memory 1502 (the memory (memory) #3) is located outside the decoder 150.

Optionally, the decoder 150 further includes a transceiver 1503, configured to receive and send data.

In addition, the processor 1401 or the processor 1501 may be a central processing unit, a general purpose processor, a digital signal processor, an application-specific integrated circuit, a field programmable gate array or another programmable logic device, a transistor logic device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of the digital signal processor and a microprocessor. In addition, the memory 1402 or the memory 1502 may include a volatile memory (volatile memory), for example, a random-access memory (random-access memory, RAM). The memory may alternatively include a non-volatile memory (non-volatile memory), for example, a flash memory (flash memory), a hard disk drive (hard disk drive, HDD), a solid-state drive (solid-state drive, SSD), cloud storage (cloud storage), network attached storage (NAS: network attached storage), or a network drive (network drive). The memory may further include a combination of the foregoing types of memories or another medium or product in any form that has a storage function.

According to still another aspect, an embodiment of this application provides an image signal processing system. The image signal processing system includes the encoder described in any one of the foregoing embodiments and the decoder described in any one of the foregoing embodiments.

An embodiment of this application further provides a chip system, including a processor and a memory. The memory is configured to store computer-readable instructions or a computer program, and the processor is configured to read the computer-readable instructions to implement the method in any one of the foregoing embodiments.

An embodiment of this application further provides a computer-readable medium. The computer-readable medium stores computer program instructions, and when the computer program instructions are executed by a computer, the method in any one of the foregoing embodiments is implemented.

An embodiment of this application further provides a computer program product. When the computer program product is executed by a computer, the method in any one of the foregoing embodiments is implemented.

A person of ordinary skill in the art may be aware that, in combination with the examples described in the embodiments disclosed in this specification, units and algorithm steps can be implemented by electronic hardware or a combination of computer software and electronic hardware. Whether the functions are performed by the hardware or the software depends on particular applications and design constraint conditions of the technical solutions. A person skilled in the art may use different methods to implement the described functions for each particular application, but it should not be considered that the implementation goes beyond the scope of this application.

A person skilled in the art may clearly understand that, for the purpose of convenient and brief description, for a detailed working process of the system and apparatus described above, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example For example, division into the units is merely logical function division and may be other division during actual implementation. For example, a plurality of units or components may be combined or integrated into another system, or some features may be ignored or not performed In addition, the displayed or discussed mutual couplings or direct couplings or communication connections may be implemented through some interfaces. The indirect couplings or communication connections between the apparatuses or units may be implemented in electrical, mechanical, or other forms.

The units described as separate parts may or may not be physically separate, and parts displayed as units may or may not be physical units, may be located in one location, or may be distributed on a plurality of network units. Some or all of the units may be selected based on an actual requirement to achieve the objectives of the solutions in the embodiments

In addition, functional units in the embodiments of this application may be integrated into one processing unit, or each of the units may exist alone physically, or two or more units are integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in the embodiments of this application

## Claims

1.  An image signal processing method, wherein the method comprises:

    obtaining (S701) a binary source $X^N$ of an image;
    performing polar code source compression on the binary source $X^N$ comprising:

      performing (S702) a polarization operation on $X^N$ based on channel polarization characteristics of polar coding, to obtain a to-be-compressed bit set $U^N$, wherein the to-be-compressed bit set $U^N$ comprises a compressed reserved bit set $U_S$ and a compressed discarded bit set $U_{SC}$; and
      obtaining (S703) a compressed reserved bit set $U_S$ from the to-be-compressed bit set $U^N$; the image signal processing method further comprises:

        performing (S704) channel coding on the compressed reserved bit set $U_S$, to obtain a coded bit sequence;
        outputting (S705) the coded bit sequence;
        performing (S706) source decoding on the compressed reserved bit set $U_S$ as polar code channel decoding on preset output values of an equivalent channel based on the compressed reserved bit set $U_S$, to obtain a source decoded bit set $U'_{S^C}$;
        obtaining (S707) error location information $T$ based on the compressed reserved bit set $U_{SC}$ and the source decoded bit set $U'_{S^C}$; **characterized in that** the image signal processing method further comprises:
        recording (S708) the compressed reserved bit set $U_S$ and the error location information $T$ as a group of data $[U_S, T]$; and training a neural network for predicting the error location information $T$ by using M of said recorded groups $[U_S, T]$ until the network converges.

2.  The method according to claim 1, wherein the obtaining (S703) a compressed reserved bit set $U_S$ from $U^N$ comprises: using, based on a sequence of equivalent channel reliabilities in descending order, bits corresponding to equivalent channel reliability ranked low in $U^N$ as $U_S$, wherein a higher source entropy of a source bit indicates lower reliability of an equivalent channel corresponding to the source bit.

3.  An image signal processing method, wherein the method comprises:

    obtaining (S1101) a received signal $Y^N$, wherein $Y^N$ is a signal obtained after a bit sequence that is obtained after polar code source compression and channel coding are performed on a binary source $X^N$ of an image is transmitted through a channel;

performing (S1102) channel decoding on $Y^N$, to obtain information bits $\hat{U}_I$ in channel decoding, and using the information bits as a compressed reserved bit set $\hat{U}_S$ on which source decoding is to be performed;

performing (S1103) the source decoding as polar code channel decoding on preset output values of an equivalent channel based on error location information $\hat{T}$ and the compressed reserved bit set $\hat{U}_S$, to obtain a compressed discarded bit set $\hat{U}_{SC}$, wherein the error location information $\hat{T}$ indicates a location of flipping a bit during polar code channel decoding;

obtaining (S1104) a decoding result $\hat{U}^N$, wherein the decoding result $\hat{U}^N$ comprises the compressed reserved bit set $\hat{U}_S$ and the obtained compressed discarded bit set $\hat{U}_{S^C}$; and

performing (S1105) a polarization operation on the decoding result $\hat{U}^N$, to obtain a reconstructed signal $\hat{X}^N$ of the binary source $X^N$,

**characterized in that** the image processing method further comprises:

inputting the compressed reserved bit set $\hat{U}_S$ to a preset neural network, to obtain the corresponding error location information $\hat{T}$ through prediction, wherein the preset neural network is a neural network that is trained based on M groups of data $[U_S, T]$ each group comprising a compressed reserved bit set $U_S$ and corresponding error location information $T$ obtained through polar code source coding until the neural network converges.

4. An encoder (120), wherein the encoder is configured to implement the image signal processing method according to any one of claims 1 to 2.

5. A decoder (130), wherein the decoder is configured to implement the image signal processing method according to claim 3.

6. A computer-readable storage medium, comprising computer program instructions, wherein when the computer program instructions are run on a computer, the computer is enabled to perform the image signal processing method according to any one of claims 1 to 3.

7. A computer program product, wherein when the computer program product runs on a computer, the computer is enabled to perform the image signal processing method according to any one of claims 1 to 3.

8. A chip system (140), comprising a processor (1401) and a memory (1402), wherein the memory (1402) is configured to store computer-readable instructions or a computer program, and the processor (1401) is configured to read the computer-readable instructions to implement the image signal processing method according to any one of claims 1 to 3.

9. An image signal processing system, comprising: the encoder according to claim 4, and the decoder according to claim 5.

**Patentansprüche**

1. Bildsignalverarbeitungsverfahren, wobei das Verfahren umfasst:

Erhalten (S701) einer binären Quelle $X^N$ eines Bilds;
Durchführen einer Polarcodequellenkompression an der binären Quelle $X^N$, die umfasst:

Durchführen (S702) eines Polarisationsvorgangs an $X^N$ basierend auf Kanalpolarisationseigenschaften einer polaren Codierung, um einen zu komprimierenden Bitsatz $U^N$ zu erhalten, wobei der zu komprimierende Bitsatz $U^N$ einen komprimierten reservierten Bitsatz $U_S$ und einen komprimierten verworfenen Bitsatz $U_Sc$ umfasst; und
Erhalten (S703) eines komprimierten reservierten Bitsatzes $U_S$ von dem zu komprimierenden Bitsatz $U^N$;
wobei das Bildsignalverarbeitungsverfahren ferner umfasst:

Durchführen (S704) der Kanalcodierung an dem komprimierten reservierten Bitsatz $U_S$, um eine codierte Bitsequenz zu erhalten;
Ausgeben (S705) der codierten Bitsequenz;

Durchführen (S706) einer Quelldecodierung an dem komprimierten reservierten Bitsatz $U_S$ als Polarcodekanaldecodierung an voreingestellten Ausgabewerten eines äquivalenten Kanals basierend auf dem komprimierten reservierten Bitsatz $U_S$, um einen decodierten Quellbitsatz $U'_S c$ zu erhalten;

Erhalten (S707) von Fehlerpositionsinformationen $T$ basierend auf dem komprimierten reservierten Bitsatz $U_S c$ und dem decodierten Quellbitsatz $U'_S c$;

**dadurch gekennzeichnet, dass** das Bildsignalverarbeitungsverfahren ferner umfasst: Aufzeichnen (S708) des komprimierten reservierten Bitsatzes $U_S$ und der Fehlerpositionsinformationen $T$ als eine Gruppe von Daten $[U_S, T]$; und Trainieren eines neuronalen Netzwerks zum Vorhersagen der Fehlerpositionsinformationen $T$ durch Verwenden von $M$ der aufgezeichneten Gruppen $[U_S, T]$ bis das Netzwerk konvergiert.

2. Verfahren nach Anspruch 1, wobei das Erhalten (S703) eines komprimierten reservierten Bitsatzes $U_S$ von $U^N$ umfasst:

Verwenden, basierend auf einer Sequenz von äquivalenten Kanalzuverlässigkeiten in absteigender Reihenfolge, von Bits, die einer äquivalenten Kanalzuverlässigkeit entsprechen, die niedrig in $U^N$ *als* $U_S$ eingeordnet sind, wobei eine höhere Quellentropie eines Quellbits eine geringere Zuverlässigkeit eines äquivalenten Kanals, der dem Quellbit entspricht, angibt.

3. Bildsignalverarbeitungsverfahren, wobei das Verfahren umfasst:

Erhalten (S1101) eines empfangenen Signals $Y^N$, wobei $Y^N$ ein Signal ist, das erhalten wird, nachdem eine Bitsequenz, die erhalten wird, nachdem die Polarcodequellenkompression und Kanalcodierung an einer binären Quelle $X^N$ eines Bilds durchgeführt werden, durch einen Kanal übertragen wird;

Durchführen (S1102) der Kanaldecodierung an $Y^N$, um Informationsbits $\hat{U}_I$ in Kanaldecodierung zu erhalten, und Verwenden der Informationsbits als einen komprimierten reservierten Bitsatz $\hat{U}_S$, an dem die Quelldecodierung durchgeführt werden soll;

Durchführen (S1103) der Quelldecodierung als Polarcodekanaldecodierung an voreingestellten Ausgabewerten eines äquivalenten Kanals basierend auf Fehlerpositionsinformationen $\hat{T}$ und dem komprimierten reservierten Bitsatz $\hat{U}_S$, um einen komprimierten verworfenen Bitsatz $\hat{U}_S c$ zu erhalten, wobei die Fehlerpositionsinformationen $\hat{T}$ eine Position eines Flippings eines Bits während der Polarcodekanaldecodierung angeben;

Erhalten (S1104) eines Decodierergebnisses $\hat{U}^N$, wobei das Decodierergebnis $\hat{U}^N$ den komprimierten reservierten Bitsatz $\hat{U}_S$ und den erhaltenen komprimierten verworfenen Bitsatz $\hat{U}_S c$ komprimiert; und

Durchführen (S1105) eines Polarisationsvorgangs an dem Decodierergebnis $U^N$, um ein rekonstruiertes Signal $\hat{X}^N$ der binären Quelle $X^N$ zu erhalten,

**dadurch gekennzeichnet, dass** das Bildverarbeitungsverfahren ferner umfasst:

Eingeben des komprimierten reservierten Bitsatzes $\hat{U}_S$ an ein voreingestelltes neuronales Netzwerk, um die entsprechenden Fehlerpositionsinformationen $\hat{T}$ durch Prädiktion zu erhalten,

wobei das voreingestellte neuronale Netzwerk ein neuronales Netzwerk ist, das basierend auf M Gruppen von Daten $[U_S T]$ trainiert wird, wobei jede Gruppe einen komprimierten reservierten Bitsatz $U_S$ umfasst und entsprechende Fehlerpositionsinformationen $T$ durch Polarcodequellencodierung erhalten werden, bis das neuronale Netzwerk konvergiert.

4. Codierer (120), wobei der Codierer konfiguriert ist, um das Bildsignalverarbeitungsverfahren nach einem der Ansprüche 1 bis 2 zu implementieren.

5. Decodierer (130), wobei der Decodierer konfiguriert ist, um das Bildsignalverarbeitungsverfahren nach Anspruch 3 zu implementieren.

6. Computerlesbares Speicherungsmedium, das Computerprogrammanweisungen umfasst, wobei, wenn die Computerprogrammanweisungen auf einem Computer ablaufen, es dem Computer ermöglicht wird, das Bildsignalverarbeitungsverfahren nach einem der Ansprüche 1 bis 3 durchzuführen.

7. Computerprogrammprodukt, wobei, wenn das Computerprogrammprodukt auf einem Computer abläuft, es dem Computer ermöglicht wird, das Bildsignalverarbeitungsverfahren nach einem der Ansprüche 1 bis 3 durchzuführen.

8. Chipsystem (140), das einen Prozessor (1401) und einen Speicher (1402) umfasst, wobei

der Speicher (1402) konfiguriert ist, um computerlesbare Anweisungen oder ein Computerprogramm zu speichern, und der Prozessor (1401) konfiguriert ist, um die computerlesbaren Anweisungen zu lesen, um das Bildsignalverarbeitungsverfahren nach einem der Ansprüche 1 bis 3 zu implementieren.

9. Bildsignalverarbeitungssystem, das umfasst: den Codierer nach Anspruch 4 und den Decodierer nach Anspruch 5.

**Revendications**

1. Procédé de traitement de signal d'image, dans lequel le procédé comprend :

l'obtention (S701) d'une source binaire $X^N$ d'une image ;
la réalisation d'une compression source de code polaire sur la source binaire $X^N$ comprenant :

la réalisation (S702) d'une opération de polarisation sur $X^N$ sur la base de caractéristiques de polarisation de canal de codage polaire, pour obtenir un ensemble de bits à compresser $U^N$, dans lequel l'ensemble de bits à compresser $U^N$ comprend un ensemble de bits réservés compressés $U_S$ et un ensemble de bits supprimés compressés $U_S c$ ; et
l'obtention (S703) d'un ensemble de bits réservés compressés $U_s$ à partir de l'ensemble de bits à compresser $U^N$ ; le procédé de traitement de signal d'image comprend en outre :

la réalisation (S704) d'un codage de canal sur l'ensemble de bits réservés compressés Us, pour obtenir une séquence de bits codés ;
la sortie (S705) de la séquence de bits codés ;
le traitement (S706) d'un décodage source sur l'ensemble de bits réservés compressés $U_S$ en tant que décodage de canal de code polaire sur des valeurs de sortie prédéfinies d'un canal équivalent sur la base de l'ensemble de bits réservés compressés Us, pour obtenir un ensemble de bits décodés source $U'_S c$ ;
l'obtention (S707) d'informations de localisation d'erreur T sur la base de l'ensemble de bits réservés compressés $U_S c$ et de l'ensemble de bits décodés source $U'_S c$ ;
**caractérisé en ce que** le procédé de traitement de signal d'image comprend en outre :
l'enregistrement (S708) de l'ensemble de bits réservés compressés $U_S$ et des informations de localisation d'erreur $T$ en tant que groupe de données $[U_S, T]$ ; et la formation d'un réseau neuronal pour prédire les informations de localisation d'erreur T à l'aide de $M$ desdits groupes enregistrés $[U_S, T]$ jusqu'à convergence du réseau.

2. Procédé selon la revendication 1, dans lequel l'obtention (S703) d'un ensemble de bits réservés compressés $U_S$ à partir de $U^N$ comprend :
l'utilisation, sur la base d'une séquence de fiabilités de canaux équivalents dans l'ordre décroissant, de bits correspondant à une fiabilité de canaux équivalents classée comme faible par $U^N$ et $U_S$ dans lequel une entropie de source supérieure d'un bit source indique une fiabilité plus faible d'un canal équivalent correspondant au bit source.

3. Procédé de traitement de signal d'image, dans lequel le procédé comprend :

l'obtention (S1101) d'un signal reçu $Y^N$, dans lequel $Y^N$ est un signal obtenu après une séquence de bits obtenue après qu'une compression source de code polaire et un codage de canal sont réalisés sur une source binaire $X^N$ d'une image transmise par le biais d'un canal ;
la réalisation (S1102) d'un décodage de canal sur $Y^N$ pour obtenir des bits d'informations $\ddot{U}_I$ dans le décodage de canal, et l'utilisation des bits d'informations en tant qu'ensemble de bits réservés compressés $\ddot{U}_S$ sur lequel le décodage source doit être réalisé ;
la réalisation (S1103) du décodage source en tant que décodage de canal de code polaire sur des valeurs de sortie prédéfinies d'un canal équivalent sur la base d'informations de localisation d'erreur $\hat{T}$ et de l'ensemble de bits réservés compressés $\hat{U}_S$, pour obtenir un ensemble de bits supprimés compressés $\hat{U}_S c$, dans lequel les informations de localisation d'erreur $\hat{T}$ indiquent une localisation d'inversion d'un bit pendant un décodage de canal de code polaire ;
l'obtention (S1104) d'un résultat de décodage $\hat{U}^N$, dans lequel le résultat de décodage $\hat{U}^N$ compresse l'ensemble de bits réservés compressé $\hat{U}_S$ et l'ensemble de bits supprimés compressés obtenus $\hat{U}_S c$ ; et
la réalisation (S1105) d'une opération de polarisation sur le résultat de décodage $\hat{U}^N$, pour obtenir un signal

reconstruit $\hat{X}^N$ de la source binaire $X^N$,

**caractérisé en ce que** le procédé de traitement d'image comprend en outre :

l'entrée de l'ensemble de bits réservés compressés $\ddot{U}_S$ dans un réseau neuronal prédéfini, pour obtenir les informations de location d'erreur correspondantes $\hat{T}$ par le biais d'une prédiction

dans lequel le réseau neuronal prédéfini est un réseau neuronal qui est formé sur la base de M groupes de données $[U_S \ T]$, chaque groupe comprenant un ensemble de bits réservés compressés $U_S$ et des informations de localisation d'erreur correspondantes $T$ obtenus par le biais d'un codage source de code polaire jusqu'à convergence du réseau neuronal.

4. Codeur (120), dans lequel
le codeur est configuré pour mettre en oeuvre le procédé de traitement de signal d'image selon l'une quelconque des revendications 1 à 2.

5. Décodeur (130), dans lequel
le décodeur est configuré pour mettre en oeuvre le procédé de traitement de signal d'image selon la revendication 3.

6. Support de stockage lisible par ordinateur, comprenant des instructions de programme informatique, dans lequel, lorsque les instructions de programme informatique sont exécutées sur un ordinateur, l'ordinateur est capable de réaliser le procédé de traitement de signal d'image selon l'une quelconque des revendications 1 à 3.

7. Produit-programme informatique, dans lequel, lorsque le produit-programme informatique est exécuté sur un ordinateur, l'ordinateur est capable de réaliser le procédé de traitement de signal d'image selon l'une quelconque des revendications 1 à 3.

8. Système de puce (140), comprenant un processeur (1401) et une mémoire (1402), dans lequel
la mémoire (1402) est configurée pour stocker des instructions lisibles par ordinateur ou un programme informatique, et le processeur (1401) est configuré pour lire les instructions lisibles par ordinateur pour mettre en oeuvre le procédé de traitement de signal d'image selon l'une quelconque des revendications 1 à 3.

9. Système de traitement de signal d'image, comprenant le codeur selon la revendication 4 et le décodeur selon la revendication 5.

Source apparatus 10

| Image source 120 | → | Encoder 100 | → | Output interface 140 |

Storage apparatus 40

30

Destination apparatus 20

| Display apparatus 220 | ← | Decoder 200 | ← | Input interface 240 |

FIG. 1

FIG. 2

EP 4 037 194 B1

$u_0 = 0$

$u_1 = 0$

$u_2 = 0$

$u_3 = 0$

$u_4 = 0$

$u_5 = 0$

$u_6 = 1$

$u_7 = 1$

FIG. 3

$u_1$ ⊕ $x_1$

$u_2$ $x_2$

FIG. 4

Input layer                    Hidden layer                    Output layer

FIG. 5

$$f\left(a_1\omega_1 + a_2\omega_2 + \ldots + a_n\omega_n + b\right)$$

FIG. 6

An encoder obtains a binary source $X^N$ of an image — S701

The encoder performs a polarization operation on $X^N$, to obtain a to-be-compressed bit set $U^N$ — S702

The encoder obtains a compressed reserved bit set $U_S$ from $U^N$ — S703

The encoder performs channel coding on $U_S$, to obtain a coded bit sequence — S704

The encoder outputs the coded bit sequence — S705

FIG. 7

FIG. 8

An encoder obtains a binary source $X^N$ of an image — S701

The encoder performs a polarization operation on $X^N$, to obtain a to-be-compressed bit set $U^N$ — S702

The encoder obtains a compressed reserved bit set $U_S$ from $U^N$ — S703

The encoder performs channel coding on $U_S$, to obtain a coded bit sequence — S704

The encoder outputs the coded bit sequence — S705

The encoder performs channel decoding on preset output values of an equivalent channel based on $U_S$, to obtain a decoded $U'_{S^c}$ — S706

The encoder obtains error location information $T$ based on $U_{S^c}$ and $U'_{S^c}$ — S707

The encoder records $U_S$ and $T$ — S708

FIG. 9

A source generates N i.i.d signals $X^N$ — 1001

Obtain a coding sequence $[U_S, U_{S^C}] = U^N = X^N G_N$ after polarization processing is performed — 1002

Use sets $S$ and $S^C$ as a fixed bit set F and an information bit set I during channel coding, set $Y^N = [U_F, 0_I] G_N$ , and input $Y^N$ into a polar code decoder — 1003

Input the fixed bit set to the polar code decoder, so that the polar code decoder becomes a polar code decoder of $0_F$; and perform decoding to obtain an estimated value $\hat{U}_i$ — 1004

1005

$\hat{U}_i = U_i$

Yes

No — 1006

Flip $\hat{U}_i$ , and record i in a set T

No — 1007

i = N?

Yes

Output $[U_S, T]$

FIG. 10

| | |
|---|---|
| A decoder obtains a received signal $Y^N$ | S1101 |

| | |
|---|---|
| The decoder performs channel decoding on $Y^N$, to obtain information bits $\hat{U}_I$ in channel decoding, and uses the information bits as a compressed reserved bit set $\hat{U}_S$ on which source decoding is to be performed | S1102 |

| | |
|---|---|
| The decoder performs channel decoding on preset output values of an equivalent channel based on error location information $\hat{T}$ and $\hat{U}_S$, to obtain a compressed discarded bit set $\hat{U}_{S^C}$ on which source decoding is to be performed | S1103 |

| | |
|---|---|
| The decoder obtains $\hat{U}^N$ | S1104 |

| | |
|---|---|
| The decoder performs a polarization operation on $\hat{U}^N$, to obtain a reconstructed signal $\hat{X}^N$ of $X^N$ | S1105 |

FIG. 11

120

Image signal processing apparatus

1202 — Polarization unit

1201 — First obtaining unit

1204 — Coding unit

1203 — Obtaining unit

1205 — Output unit

1206 — Second obtaining unit

1207 — Recording unit

FIG. 12

130

Image signal processing apparatus

1301 — Obtaining unit

1302 — First decoding unit

1303 — Second decoding unit

1304 — Obtaining unit

1305 — Polarization unit

1306 — Prediction unit

FIG. 13

FIG. 14

FIG. 15

**REFERENCES CITED IN THE DESCRIPTION**

**Non-patent literature cited in the description**

- **HARM S CRONIE et al.** Lossless source coding with polar codes. *Proc., IEEE International Symposium on Information Theory, ISIT 2010,* 13 June 2010, 904-908

- Performance of polar codes for channel and source coding. **NADINE HUSSAMI et al.** ARXIV.ORG, CORNELL UNIVERSITY LIBRARY. OLIN LIBRARY CORNELL UNIVERSITY, 16 January 2009
- **KORADA SATISH BABU.** Polar codes for channel and source coding. *Ph.D. Thesis, EPFL Lausanne,* 28 May 2009, 1-181